# EUROPEAN PATENT APPLICATION

(11) **EP 4 380 321 A1**
(43) Date of publication of application: **05.06.2024**
(21) Application number: 23213421.3
(22) Date of filing: 30.11.2023
(51) Int. Cl.: H05K 1/02, H01L 23/473, H05K 1/18

(54) **CIRCUIT BOARD WITH BUILT-IN COMPONENTS AND METHOD OF MANUFACTURING CIRCUIT BOARD WITH BUILT-IN COMPONENTS**

(30) Priority: 01.12.2022 JP 2022192977
(71) Applicant: Nabtesco Corporation, Tokyo 102-0093 (JP)
(72) Inventor: Koizumi, Katsuhiro, Chiyoda-ku, Tokyo, 102-0093 (JP)
(74) Representative: Grünecker Patent- und Rechtsanwälte PartG mbB

(57) **Abstract**

A circuit board with built-in components (1) includes: a first conductive wiring layer (10); a second conductive wiring layer (20); a first insulating layer (30) stacked to be sandwiched between the first conductive wiring layer (10) and the second conductive wiring layer (20); an electronic component (40) built in the first insulating layer (30) and electrically connected to the first conductive wiring layer (10) and the second conductive wiring layer (20); a heat dissipating layer (50) that has a heat dissipating part (70) that dissipates heat generated by the electronic component (40); and a second insulating layer (60) stacked to be sandwiched between the second conductive wiring layer (20) and the heat dissipating layer (50). Inside the second insulating layer (60), a closed coolant flow path (80) in which a coolant is enclosed is formed. The coolant flow path (80) thermally connects the electronic component (40) and the heat dissipating layer (50).

## Description

### BACKGROUND OF THE INVENTION

### 1. Field of the Invention

The present invention relates to circuit boards with built-in components and a method of manufacturing circuit boards with built-in components.

### 2. Description of the Related Art

In conventional electronic devices, technology for mounting electronic components on the surface of a printed board has been generally used. Meanwhile, it can be expected to increase the density in electronic circuits by adopting a circuit board with built-in components in which electronic components are mounted inside a printed board.

[Patent Literature 1] JP2008-177552

Circuit boards with built-in components have an advantage of miniaturization due to high-density mounting, but there is a problem that heat dissipation of built-in components is poor.

Patent literature 1 discloses a heat dissipation structure using a thermal via. Since this heat dissipation structure has a thermal resistance (difficulty in heat transfer) from the built-in component that generates heat to the heat dissipation space, however, there is a problem in that the component temperature rises, leading to a decrease in reliability.

### SUMMARY OF THE INVENTION

The present invention addresses the issue described above, and a purpose thereof is to reduce the thermal resistance of a circuit board with built-in components and improve heat dissipation.

A circuit board with built-in components according to an aspect of the present invention includes: a first conductive wiring layer; a second conductive wiring layer; a first insulating layer stacked to be sandwiched between the first conductive wiring layer and the second conductive wiring layer; an electronic component built in the first insulating layer and electrically connected to the first conductive wiring layer and the second conductive wiring layer; a heat dissipating layer that has a heat dissipating part that dissipates heat generated by the electronic component; and a second insulating layer stacked to be sandwiched between the second conductive wiring layer and the heat dissipating layer. Inside the second insulating layer, a closed coolant flow path in which a coolant is enclosed is formed, and the coolant flow path thermally connects the electronic component and the heat dissipating layer.

In a circuit board with built-in components according to an embodiment, the heat dissipating layer may be a conductor.

In a circuit board with built-in components according to an embodiment, the heat dissipating part may be provided at a position that does not overlap the electronic component as seen in a thickness direction.

In a circuit board with built-in components according to an embodiment, the coolant flow path may be formed to tilt downward from a position where the heat dissipating part is provided toward a position where the electronic component built in.

In a circuit board with built-in components according to an embodiment, a portion in at least one of the second conductive wiring layer or the heat dissipating layer constituting the coolant flow path may have a larger surface roughness than a portion not constituting the coolant flow path.

In a circuit board with built-in components according to an embodiment, the surface roughness may include a groove provided along a direction in which the coolant flows.

Another aspect of the present invention relates to a method of manufacturing a circuit board with built-in components. The method includes: forming a first conductive wiring layer; forming a second conductive wiring layer; forming a first insulating layer sandwiched between the first conductive wiring layer and the second conductive wiring layer; electrically connecting an electronic component to the first conductive wiring layer and the second conductive wiring layer and building the electronic component in the first insulating layer; forming a heat dissipating layer having a heat dissipating part that dissipates heat generated by the electronic component; forming a second insulating layer sandwiched between the second conductive wiring layer and the heat dissipating layer, in which second insulating layer a coolant flow path that thermally connects the electronic component and the heat dissipating layer is formed inside; and enclosing a coolant in the coolant flow path.

A method according to an embodiment may include processing a portion in at least one of the second conductive wiring layer or the heat dissipating layer constituting the coolant flow path to have a larger surface roughness than a portion not constituting the coolant flow path.

Optional combinations of the aforementioned constituting elements, and mutual substitution of constituting elements and implementations of the present invention between methods, apparatuses, programs, transitory or non-transitory recording mediums carrying the program, systems, etc. may also be practiced as additional modes of the present invention.

According to the disclosure, it is possible to reduce the thermal resistance of a circuit board with built-in components and improve heat dissipation.

### BRIEF DESCRIPTION OF THE DRAWINGS

Fig. 1 is a cross-sectional view of a circuit board with built-in components according to the first embodiment from a longitudinal side;
Fig. 2A shows a circuit board with built-in components in which the heat dissipating part is formed by an air-cooled heat sink;
Fig. 2B is a circuit board with built-in components in which the heat dissipating part is formed by a liquid-cooled jacket;
Fig. 3 is a schematic view of the circuit board with built-in components of Fig. 1 from above;
Fig. 4 is a schematic view of the circuit board with built-in components in which the heat dissipating part is provided at a position that does not overlap the electronic component as seen in the thickness direction;
Fig. 5 is a flowchart showing steps in a method according to the second embodiment of manufacturing a circuit board with built-in components; and
Fig. 6 is a flowchart showing steps in another method according to the second embodiment of manufacturing a circuit board with built-in components.

### DETAILED DESCRIPTION OF THE INVENTION

Hereinafter, the invention will be described based on a preferred embodiment with reference to drawings. The embodiment does not limit the scope of the invention but exemplifies the invention. Not all of the features and the combinations thereof described in the embodiment are necessarily essential to the invention. Identical or like constituting elements, members, processes shown in the drawings are represented by identical symbols and a duplicate description will be omitted as appropriate. The scales and shapes shown in the figures are defined for convenience's sake to make the explanation easy and shall not be interpreted limitatively unless otherwise specified. Terms like "first", "second", etc. used in the specification and claims do not indicate an order or importance by any means unless otherwise specified and are used to distinguish a certain feature from the others. Those of the members that are not important in describing the embodiment are omitted from the drawings.

### [First embodiment]

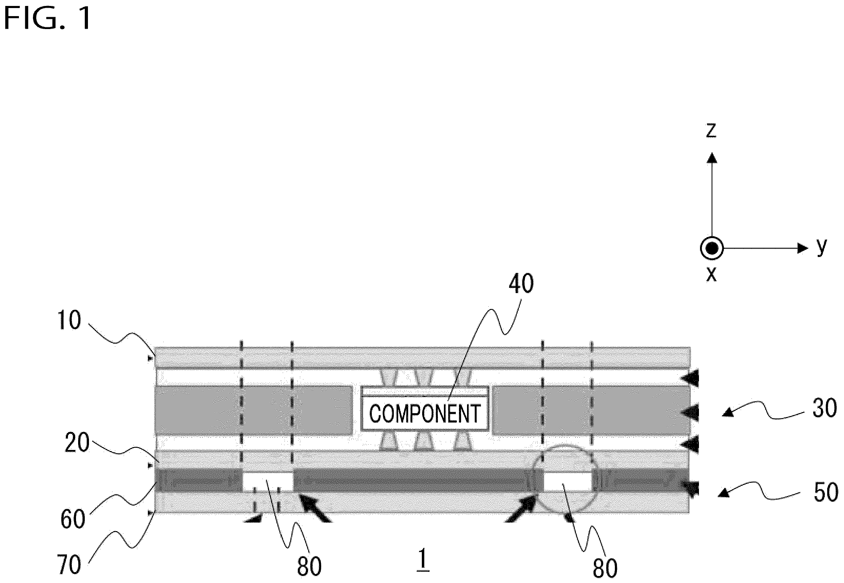

Fig. 1 is a cross-sectional view that results when a circuit board with built-in components 1 according to the first embodiment is placed on a horizontal plane and viewed from a longitudinal side. In this specification, the longitudinal direction of the circuit board placed on a horizontal plane is defined as the x axis, the horizontal direction is defined as the y axis, and the vertically upward direction is defined as the z axis. The circuit board with built-in components 1 includes a first conductive wiring layer 10, a second conductive wiring layer 20, a first insulating layer 30, an electronic component 40, a heat dissipating layer 50, and a second insulating layer 60. The first insulating layer is sandwiched between the first conductive wiring layer 10 and the second conductive wiring layer 20. The electronic component 40 is built in the first insulating layer 30 and is electrically connected to the first conductive wiring layer 10 and the second conductive wiring layer 20. The heat dissipating layer 50 has a heat dissipating part 70 that dissipates heat generated by the electronic component 40. The second insulating layer 60 is sandwiched between the second conductive wiring layer 20 and the heat dissipating layer 50. Inside the second insulating layer 60, a closed coolant flow path 80 in which a coolant is enclosed is formed. The coolant flow path 80 thermally connects the electronic component 40 and the heat dissipating layer 50.

In this example, the first conductive wiring layer 10 and the second conductive wiring layer 20 are made of a copper foil.

The first insulating layer 30 may include a core layer and a prepreg member.

The electronic component 40 may be any electronic component mounted inside the board and emits heat and is exemplified by a semiconductor element, a resistor, a capacitor, or an inductor.

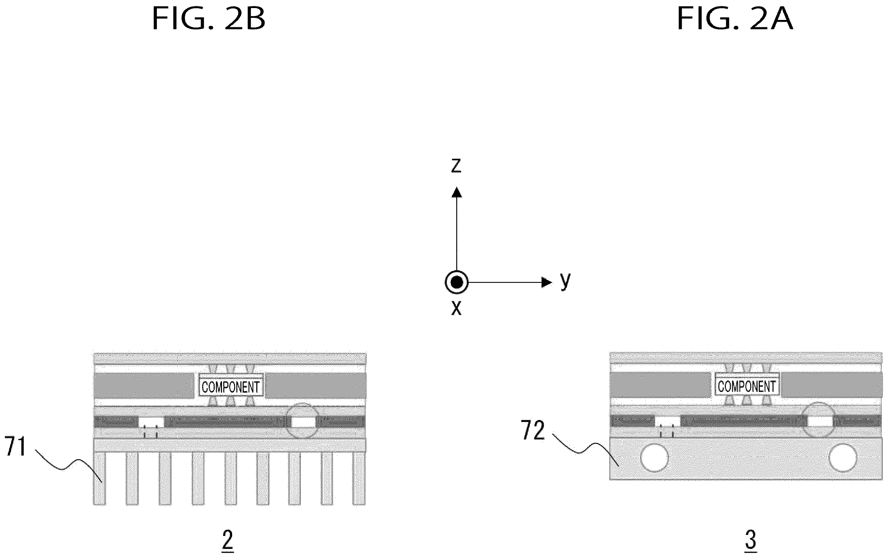

The heat dissipating part 70 may be, for example, an air-cooled heat sink or a liquid-cooled jacket. Figs. 2A and 2B show a circuit board with built-in components 2 in which the heat dissipating part is formed by an air-cooled heat sink 71 (Fig. 2A) and a circuit board with built-in components 3 in which the heat dissipating part is formed by a liquid-cooled jacket 72 (Fig. 2B).

The thicker the second insulating layer 60 provided with the coolant flow path 80, the larger the flow rate of the coolant and so the higher the cooling efficiency. When a further insulating layer is provided in the circuit board with built-in components, for example, the thickness of the second insulating layer 60 may be larger than the thickness of the further insulating layer.

The coolant enclosed in the coolant flow path 80 may be a fluorinated coolant exemplified by chlorofluorocarbon (CFC), hydrochlorofluorocarbon (HCFC), hydrofluorocarbon (HFC), or hydrofluoroolefin (HFO).

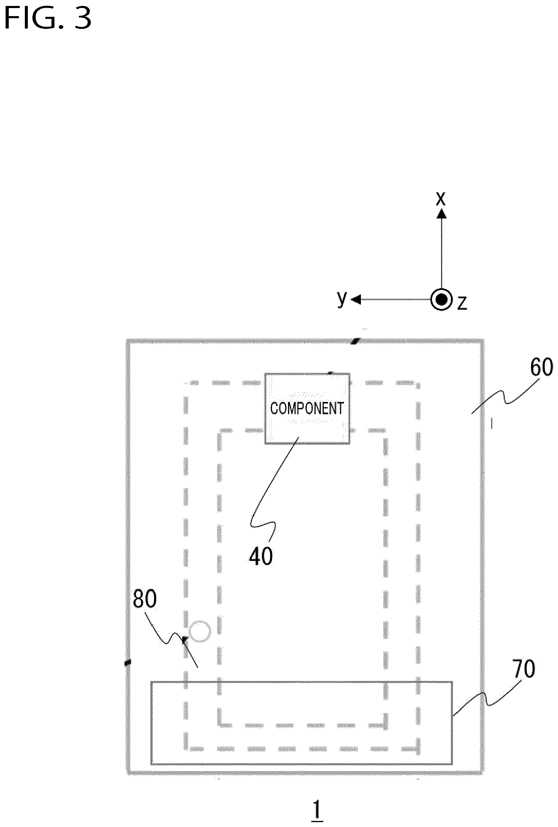

Fig. 3 is a schematic view of the circuit board with built-in components 1 from above. The coolant (liquid) enclosed in the closed annular coolant flow path 80 is heated and evaporated at the portion (heat generating portion) in which the electronic component 40 is provided. The evaporated coolant moves in the coolant flow path 80 as far as the heat dissipating part 70, condenses, and returns to a liquid. The condensed liquid moves again in the coolant flow path 80 by capillary action and returns to the heat generating part. This is an application of the operating principle of a heat pipe to the built-in structure of a printed board. By repeating this operation, coolant circulation is realized without requiring energy such as that of a pump. That is, by enclosing the coolant inside the second insulating layer to form a closed coolant flow path, and providing a configuration in which the coolant flow path thermally connects the electronic component and the heat dissipating layer, it is possible to reduce the thermal resistance from the electronic component to the heat dissipating part and improve the heat dissipation performance without requiring power for coolant drive.

In further accordance with the present embodiment, the coolant flow path 80 need only be provided in the existing insulating layer (second insulating layer 60) so that it is not necessary to provide an additional structure (layer). Therefore, there is no need to change the existing printed board manufacturing process, and the complexity of the manufacturing process can be reduced.

The heat dissipating layer 50 may be a conductor. By configuring the heat dissipating layer 50 as a conductor, it can be grounded as a frame ground. Furthermore, the larger the electrical conductivity of a conductor, the larger the thermal conductivity so that the heat dissipation effect can be further enhanced by configuring the heat dissipating layer 50 as a conductor. In this case, too, the heat dissipating layer 50 is insulated from the second conductive wiring layer 20 by the second insulating layer 60 so that electric leakage and electric shock can be prevented.

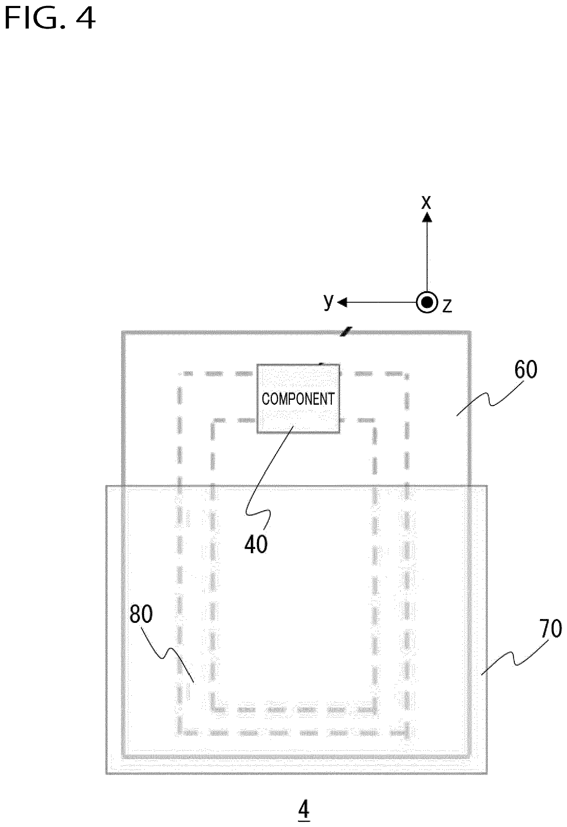

The heat dissipating part 70 may be provided at a position that does not overlap the electronic component 40 as seen in the thickness direction. Fig. 4 is a schematic view of the circuit board with built-in components 1 of this embodiment from above. By configuring the heat dissipating part 70 and the electronic component 40 not to overlap, electromagnetic noise generated by the electronic component such as a semiconductor element can be prevented from being amplified by the heat dissipating part.

When the above configuration is adopted, the coolant flow path 80 may be formed to tilt downward from a position where the heat dissipating part 70 is provided toward a position where the electronic component 40 is built in. By configuring the coolant flow path 80 so that the position toward the heat dissipating part 70 is higher than the position toward the electronic component 40 to tilt the coolant flow path 80 downward from the side of the heat dissipating part 70 toward the side of the electronic component 40, it is possible to increase the cooling efficiency without obstructing the flow of coolant.

The portion in at least one of the second conductive wiring layer 20 or the heat dissipating layer 50 constituting the coolant flow path 80 may have a larger surface roughness than the portion not constituting the coolant flow path 80. For example, the portion in at least one of the second conductive wiring layer 20 or the heat dissipating layer 50 constituting the coolant flow path 80 may include a groove, a scratch damage, unevenness having a high areal density, etc. In this case, at least one of the upper or lower parts of the inner wall of the coolant flow path 80 will be a rough surface. In this case, the effect of capillary action is improved as compared with the case where the inner surface of the coolant flow path 80 is smooth. Therefore, the flow of coolant in the coolant flow path 80 is promoted, and the cooling effect provided by heat exchange is improved. As described above, the roughness of the surface can be realized in the substrate manufacturing process by forming the roughness by a groove, a scratch damage, unevenness having a high areal density, etc.

In particular, the roughness of the surface described above may comprise a groove provided along the direction in which the coolant flows. By forming the roughness of the surface of the portion at least one of the second conductive wiring layer 20 or the heat dissipating layer 50 constituting the coolant flow path 80 by a groove along the direction in which the coolant flows, the effect of capillary action can be further improved, and the cooling efficiency can be improved.

### [Second embodiment]

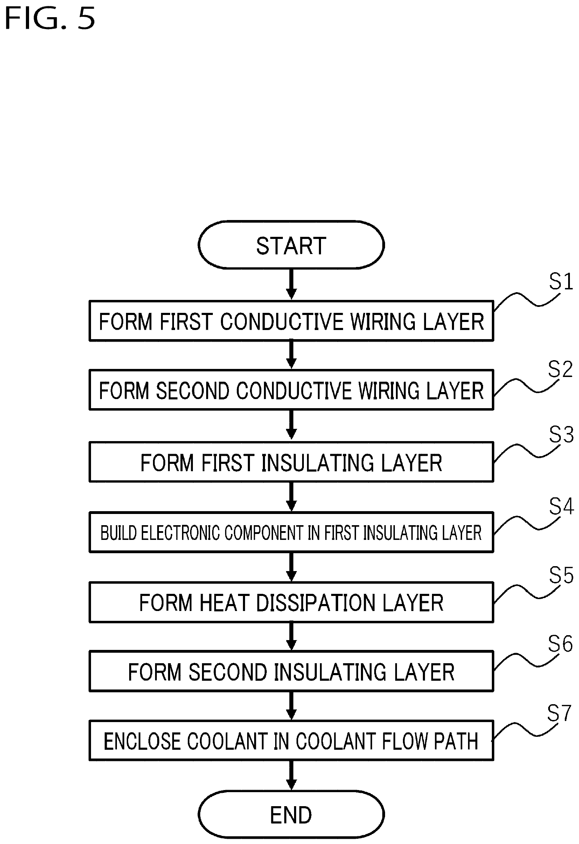

Fig. 5 is a flowchart showing steps in a method of manufacturing a circuit board with built-in components. The method includes step S1 of forming a first conductive wiring layer, step S2 of forming a second conductive wiring layer, step S3 of forming a first insulating layer sandwiched between the first conductive wiring layer and the second conductive wiring layer, step S4 of electrically connecting an electronic component to the first conductive wiring layer and the second conductive wiring layer and building the electronic component in the first insulating layer, step S5 of forming a heat dissipating layer having a heat dissipating part that dissipates heat generated by the electronic component, step S6 of forming a second insulating layer sandwiched between the second conductive wiring layer and the heat dissipating layer, in which second insulating layer a coolant flow path that thermally connects the electronic component and the heat dissipating layer is formed inside; and step 7 of enclosing a coolant in the coolant flow path.

According to this embodiment, a circuit board with built-in components with reduced thermal resistance and improved heat dissipation can be manufactured.

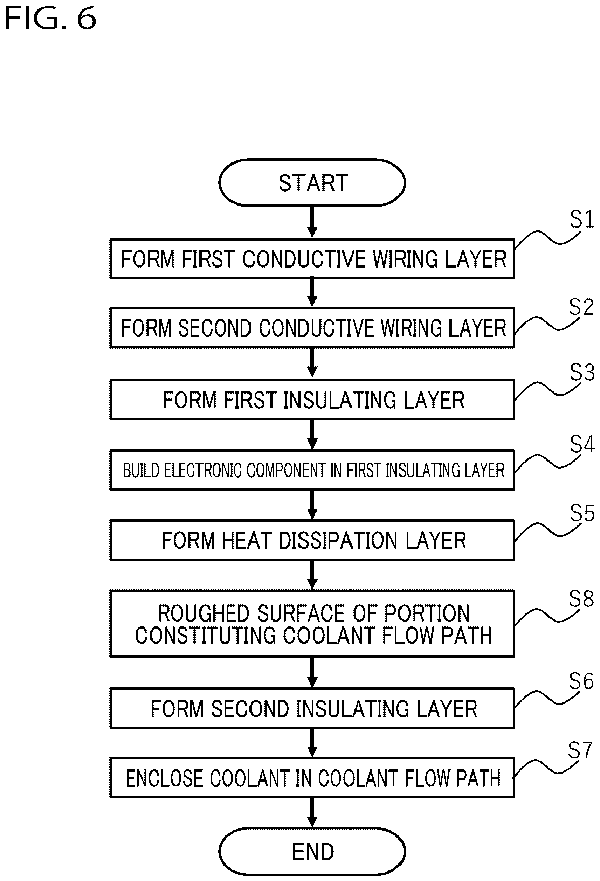

Fig. 6 is a flowchart showing steps in another method of manufacturing a circuit board with built-in components. The method includes step S1 of forming a first conductive wiring layer, step S2 of forming a second conductive wiring layer, step S3 of forming a first insulating layer sandwiched between the first conductive wiring layer and the second conductive wiring layer, step S4 of electrically connecting an electronic component to the first conductive wiring layer and the second conductive wiring layer and building the electronic component in the first insulating layer, step S5 of forming a heat dissipating layer having a heat dissipating part that dissipates heat generated by the electronic component, step S8 of processing a portion in at least one of the second conductive wiring layer or the heat dissipating layer constituting the coolant flow path to have a larger surface roughness than a portion not constituting the coolant flow path, step S6 of forming a second insulating layer sandwiched between the second conductive wiring layer and the heat dissipating layer, in which second insulating layer a coolant flow path that thermally connects the electronic component and the heat dissipating layer is formed inside; and step 7 of enclosing a coolant in the coolant flow path.

According to this embodiment, it is possible to manufacture a circuit board with built-in components in which the thermal resistance is further reduced and the heat dissipation is further improved.

In the above method, the order in which the steps are executed may not necessarily be as shown in Figs. 5 and 6. Further, a further step may be executed between the above steps. For example, step S1 of forming the first conductive wiring layer, step S2 of forming the second conductive wiring layer, step S3 of forming the first insulating layer, and step S6 of forming the second insulating layer may be executed in any order.

Described above is an explanation based on an embodiment. The embodiment is intended to be illustrative only and it will be understood by those skilled in the art that variations and modifications are possible within the claim scope of the present invention and that such variations and modifications are also within the claim scope of the present invention. Therefore, the description in this specification and the drawings shall be treated to serve illustrative purposes and shall not limit the scope of the invention.

The substrate material (FR4, CEM3, etc.) and the insulating layer material such as a prepreg are not particularly limited and may be any suitable material. The thickness of the conductor layer is not particularly limited and may be thicker or thinner than 36 um, which is common. The present technology can be applied to both rigid substrates and flexible substrates. According to this variation, flexibility of configuration can be increased.

Any combination of the embodiment and the variation described above will also be useful as an embodiment of the present invention. New embodiments created by the combination provide the advantages of embodiment and the variation combined.

An explanation based on the embodiment and variations has been given above. In understanding the technical idea derived from abstracting the embodiment and the variations, the technical idea shall not be interpreted as being limited to the details of the embodiment and the variations. The embodiment and the variations described above are merely specific examples, and a number of design modifications such as modification, addition, deletion, etc. of constituting elements may be made. The details subject to such design modification are emphasized in the embodiment by using a phrase "embodiment". However, details not referred to as such are also subject to design modification.

### [INDUSTRIAL APPLICABILITY]

Circuit boards with built-in components accoding to above embodiments can be widely used in power electronics circuits such as motor inverters, DCDC converters, ACDC converters, and DCAC inverters.

### [REFERENCE SIGNS LIST]

1 circuit board with built-in components,
10 first conductive wiring layer,
20 second conductive wiring layer,
30 first insulating layer,
40 electronic component,
50 heat dissipating layer,
60 second insulating layer,
70 heat dissipating part,
80 coolant flow path,
S1 step of forming first conductive wiring layer,
S2 step of forming second conductive wiring layer,
S3 step of forming first insulating layer,
S4 step of electrically connecting electronic component to first conductive wiring layer and second conductive wiring layer and building electronic component in first insulating layer,
S5 step of forming heat dissipating layer having heat dissipating part,
S6 step of forming second insulating layer,
S7 step of enclosing coolant in coolant flow path,
S8 step of processing portion in second conductive wiring layer or heat dissipating layer.

## Claims

1. A circuit board with built-in components (1) comprising:
a first conductive wiring layer (10);
a second conductive wiring layer (20);
a first insulating layer (30) stacked to be sandwiched between the first conductive wiring layer (10) and the second conductive wiring layer (20);
an electronic component (40) built in the first insulating layer (30) and electrically connected to the first conductive wiring layer (10) and the second conductive wiring layer (20);
a heat dissipating layer (50) that has a heat dissipating part (70) that dissipates heat generated by the electronic component (40); and
a second insulating layer (60) stacked to be sandwiched between the second conductive wiring layer (20) and the heat dissipating layer (50), wherein
inside the second insulating layer, a closed coolant flow path (80) in which a coolant is enclosed is formed, and the coolant flow path (80) thermally connects the electronic component (40) and the heat dissipating layer (50).

2. The circuit board with built-in components (1) according to claim 1, wherein
the heat dissipating layer (50) is a conductor.

3. The circuit board with built-in components (1) according to claim 1 or 2, wherein
the heat dissipating part (70) is provided at a position that does not overlap the electronic component (40) as seen in a thickness direction.

4. The circuit board with built-in components (1) according to claim 3, wherein
the coolant flow path (80) is formed to tilt downward from a position where the heat dissipating part (70) is provided toward a position where the electronic component (40) built in.

5. The circuit board with built-in components (1) according to claim 1 or 2, wherein
a portion in at least one of the second conductive wiring layer (20) or the heat dissipating layer (50) constituting the coolant flow path (80) has a larger surface roughness than a portion not constituting the coolant flow path (80).

6. The circuit board with built-in components (1) according to claim 5, wherein
the surface roughness includes a groove provided along a direction in which the coolant flows.

7. A method of manufacturing a circuit board with built-in components, comprising:
forming (S1) a first conductive wiring layer;
forming (S2) a second conductive wiring layer;
forming (S3) a first insulating layer sandwiched between the first conductive wiring layer and the second conductive wiring layer;
electrically connecting (S4) an electronic component to the first conductive wiring layer and the second conductive wiring layer and building the electronic component in the first insulating layer;
forming (S5) a heat dissipating layer having a heat dissipating part that dissipates heat generated by the electronic component;
forming (S6) a second insulating layer sandwiched between the second conductive wiring layer and the heat dissipating layer, in which second insulating layer a coolant flow path that thermally connects the electronic component and the heat dissipating layer is formed inside; and
enclosing (S7) a coolant in the coolant flow path.

8. The method according to claim 7, further comprising: processing (S8) a portion in at least one of the second conductive wiring layer or the heat dissipating layer constituting the coolant flow path to have a larger surface roughness than a portion not constituting the coolant flow path.
